# EUROPEAN PATENT SPECIFICATION

(11) **EP 3 248 942 B1**
(45) Date of publication and mention of the grant of the patent: **03.03.2021**
(21) Application number: 16740255.1
(22) Date of filing: 21.01.2016
(51) Int. Cl.: H01F 1/34, H01F 1/37, C01G 49/00, H05K 9/00

(54) **RESIN COMPOSITION CONTAINING A HEXAGONAL PLATE SHAPED FERRITE POWDER, MANUFACTURING METHOD THEREOF, AND MOLDED PRODUCT FORMED FROM THE RESIN COMPOSITION**
HARZZUSAMMENSETZUNG ENTHALTEND EIN FERRITPULVER IN FORM HEXAGONALER PLÄTTCHEN, VERFAHREN ZU DEREN HERSTELLUNG UND FORMGEGENSTAND GEFORMT AUS DER HARZZUSAMMENSETZUNG
COMPOSITION DE RÉSINE AVEC UNE POUDRE DE FERRITE EN FORME DE PLAQUES HEXAGONALES, SON PROCÉDÉ DE FABRICATION ET OBJET MOULÉ UTILISANT LADITE COMPOSITION DE RÉSINE

(30) Priority: 22.01.2015 JP 2015010574
(43) Date of publication of application: 29.11.2017
(73) Proprietor: Powdertech Co., Ltd., Kashiwa-shi, Chiba 277-8557 (JP)
(72) Inventor: AGA, Koji, Kashiwa-shi Chiba 277-8557 (JP); IGARASHI, Tetsuya, Kashiwa-shi Chiba 277-8557 (JP)
(74) Representative: Vossius & Partner Patentanwälte Rechtsanwälte mbB
(86) International application number: PCT/JP2016/051715
(87) International publication number: WO 2016/117648

(56) References cited:
- EP-A1- 2 418 660
- WO-A1-2014/163079
- JP-A- S6 140 823
- JP-A- H03 257 801
- JP-A- H03 285 302
- JP-A- 2002 260 913
- G. R. GORDANI ET AL.: 'Enhanced magnetic properties of substituted Sr-hexaferrite nanoparticles synthesized by co-precipitation method' CERAMICS INTERNATIONAL vol. 40, no. 3, April 2014, pages 4945 - 4952, XP055467345
- GHOLAM ET AL: "Enhanced magnetic properties of substituted Sr-hexaferrite nanoparticles synthesized by co-precipitation method", CERAMICS INTERNATIONAL, vol. 40, no. 3, 1 April 2014 (2014-04-01), pages 4945-4952, XP055467345, NL ISSN: 0272-8842, DOI: 10.1016/j.ceramint.2013.10.096

## Description

### [Technical Field]

The present invention relates to a resin composition containig a hexagonal plate shaped ferrite powder which has a residual magnetization and a coercive force larger than those of spherical hard ferrite powder, and has a specific frequency characteristic, and a method of manufacturing the same with low cost. Furthermore, the present invention relates to a molded product formed from the resin composition.

### [Background Art]

Conventionally, magnetic substances of oxides including ferrite have been used as radio wave absorber, in particular, as radio wave absorber in a high frequency band. In particular, various hexagonal plate shaped ferrites have been proposed as ferrites that show excellent properties. On the other hand, metal materials have been used as material that reflect electromagnetic waves.

Patent Document 1 (Japanese Patent Laid-Open No. 2007-250823) discloses a magnetic powder for radio wave absorber using the ferrite powder of the magnetoplumbite-type hexagonal crystal represented by SrFe₍₁₂₋ₓ₎AlₓO₁₉ (x=1.0 to 2.2).

It is disclosed that if the magnetic powder for radio wave absorber is used, a thin sheet with a thickness of 0.5 mm or less having a stable attenuation of 10 dB or more, or even 15 dB or more, in the vicinity of 75 GHz can be provided.

Patent Document 2 (Japanese Patent Laid-Open No. 2008-66364) discloses a magnetic powder for radio wave absorber using the ferrite powder of the hexagonal crystal including BaₓZn_{y}Fe_{z}O₂₂ (1.5≤x≤2.2, 1.2≤y≤2.5, 11≤z≤13).

It is disclosed that the magnetic powder for radio wave absorber can improve the imaginary part µ" of complex magnetic permeability in the high-frequency range of 1 GHz or more, particularly in the range of 3 to 6 GHz. So, if the magnetic powder for radio wave absorber is compared with the ferrite powder of the Y-type hexagonal crystal manufactured by the conventional method, a radio wave absorber having a smaller thickness achieves the same or higher radio wave absorbing performance.

Patent Document 3 (Japanese Patent Laid-Open No. 2011-66430) discloses magnetic powder for radio wave absorber using the ferrite powder of Z-type hexagonal crystal constituted from the component A (one or more alkaline-earth metal elements and Pb), the component M (one or more metal elements other than divalent Fe), Fe and oxygen.

It is disclosed that the magnetic powder for radio wave absorber can remarkably improve the imaginary part µ" of complex magnetic permeability in the high-frequency range of 1 GHz or more, particularly in the range of 3 to 6 GHz. So, the radio wave absorber with a smaller thickness achieves the same or higher radio wave absorbing performance than the ferrite powder of Z-type hexagonal crystal having the same composition manufactured by a conventional method.

These ferrites of hexagonal crystal disclosed in Patent Documents 1 to 3 intend to achieve both improvement of the radio wave absorbing performance and thinner thickness in an electromagnetic wave absorber made therefrom by specifying the ferrite composition, the peak particle diameter in a particle size distribution, the volume fraction in a particle size distribution, and the aspect ratio.

However, any one of Patent Documents discloses just magnetic filler used for a radio wave absorber at a frequency of 1 GHz or more, i.e. no filler for an electromagnetic wave absorber used at a frequency of lower than 1 GHz is disclosed. Further, the electromagnetic wave absorbers using the magnetic fillers disclosed in Patent Documents 1 to 3 do not intend to achieve the compatibility among the residual magnetization, the coercive force and the radio wave absorbability of magnetic filler.

A method of producing Sr-hexaferrite particles by dry mixing the precursors before heat treatment is disclosed in Patent Document 4.

The magnetic properties of substituted Sr-hexaferrite nanoparticles synthesized by coprecipitation have been studied in Non-Patent Document 1.

### [Documents Cited]

### [Patent Document]

[Patent Document 1] Japanese Patent Laid-Open No. 2007-250823
[Patent Document 2] Japanese Patent Laid-Open No. 2008-66364
[Patent Document 3] Japanese Patent Laid-Open No. 2011-66430
[Patent Document 4] EP 2 418 660 A1

### [Non-Patent Document]

[Non-Patent Document 1] Gordani G.R. et al., Ceramics International 40 (2014), pp. 4945-4952

### [Summary of Invention]

### [Problems to be Solved]

Objects of the present invention are to provide a resin composition containing a ferrite powder having a residual magnetization and a coercive force larger than those of spherical hard ferrite particles, magnetic permeability µ" is maximum in a specific frequency range, a manufacturing method thereof,
and a molded product made from the resin composition.

### [Means to Solve the Problem]

After the extensive investigation to solve the problems described above, the present inventors thought out that a hexagonal plate shaped ferrite powder having a specific composition have a residual magnetization and a coercive force larger than those of spherical hard ferrite particles, and magnetic permeability µ" is maximum in a specific frequency range, and the present invention was accomplished. The ferrite particles refer to individual particles or a mass having a specific particle diameter. The ferrite powder refers to a mass of the whole ferrite particles and includes an aggregate of the ferrite powder.

The present invention provides a resin composition as defined in claims 1 to 4.

The hexagonal plate shaped ferrite powder used in the present invention includes an aggregate of the hexagonal plate shaped ferrite powder.

The hexagonal plate shaped ferrite powder used in the present invention has a length in the minor axis direction of 0.5 to 3 µm and an aspect ratio of 3.5 to 9.

The hexagonal plate shaped ferrite powder used in the present invention is preferable to have a volume average particle diameter of 3 to 20 µm.

The hexagonal plate shaped ferrite powder used in the present invention is preferable to have an amount of Cl eluted of 1 to 100 ppm.

The present invention provides a resin composition characterized in containing 50 to 99.5 wt% of the hexagonal plate shaped ferrite powder.

The present invention provides a molded product formed from the resin composition. This is specified in claim 5; claim 6 specifies a radio wave absorber formed from the molded product.

The present invention provides a method of manufacturing a resin composition as defined in claim 7 or 8.

The method of manufacturing the resin composition according to the present invention preferably further comprises wet pulverizing the fired product manufactured by the firing, heat treating the pulverized product at 750 to 1050°C after rinsing, dehydrating, and drying.

### [Advantages of the Invention]

As the hexagonal plate shaped ferrite powder used in the present invention has a hexagonal plate shape and a specific composition, the residual magnetization and the coercive force thereof are larger than those of spherical hard ferrite powder, and the magnetic permeability µ" is maximum in a specific frequency range. So, if the hexagonal plate shaped ferrite powder is used as a filler for a resin molded product, as the resin molded product has high particle orientation, the resin molded product is not only high in energy product than spherical ferrite powder but also has specific frequency properties. Further, the resin molded product using the hexagonal plate shaped ferrite powder closely contact to a metal material for reflecting electromagnetic waves can be used for a long period without corrosion. If a metal material for reflecting electromagnetic waves has magnetic properties, the resin molded product using the hexagonal plate shaped ferrite powder is suitably used because the resin molded product is magnetized and closely contact to the metal material without adhesive.

### [Brief Description of Drawing]

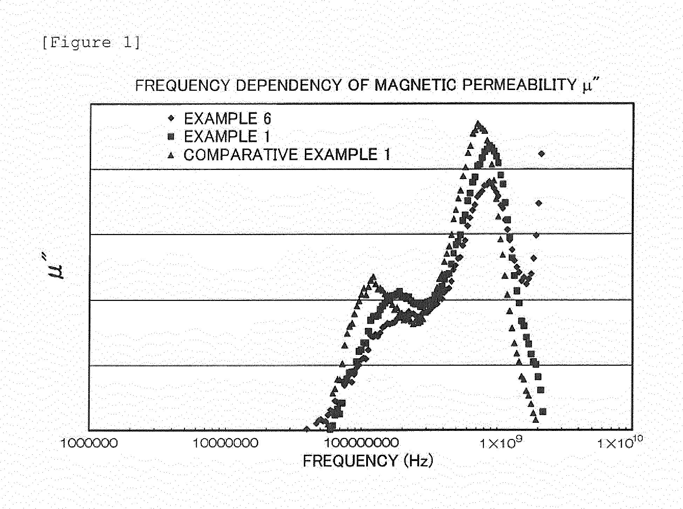

[Figure 1] Figure 1 is a graph showing the frequency dependency of the magnetic permeability µ" in Examples 1 and 6 and Comparative Example 1.

### [Preferred Embodiments of the Invention]

The embodiments of the present invention will be described.

### <Hexagonal plate shaped ferrite powder used in the present invention>

The hexagonal plate shaped ferrite powder used in to the present invention has a hexagonal plate shape as described above. As a result, the residual magnetization and the coercive force thereof are larger than those of spherical hard ferrite powder. Further, the hexagonal plate shaped ferrite powder preferably includes an aggregate of the hexagonal plate shaped ferrite powder.

The hexagonal plate shaped ferrite powder used in the present invention has a length in the minor axis direction of 0.5 to 3 µm and an aspect ratio of 3.5 to 9. If the hexagonal plate shaped ferrite powder has the length in the minor axis direction and the aspect ratio in the ranges, not only high orientation but also high coercive force and residual magnetization is achieved if used as a filler for a resin molded product. If the length in the minor axis direction is less than 0.5 µm, the volume density of ferrite powder increases to make the upper limit of the filler content lower. If the length in the minor axis direction exceeds 3 µm, the residual magnetization and the coercive force of ferrite powder decrease not to achieve the desired magnetic performance. If the aspect ratio is less than 3.5, the orientation of particles is poor and the magnetic properties and frequency properties of a resin molded product may be poor if used as a filler. If the aspect ratio is more than 9, the volume density of ferrite powder increases and it makes the upper limit of the filler content lower.

### (Determination of the length in the minor axis direction and aspect ratio)

The cross section of the specimen for examining magnetic permeability/permittivity described later is polished, and the cross sectional image of the ferrite powder is photographed with JSM-6060A manufactured by JEOL Ltd., with an accelerating voltage of 20 kV and magnification of 450-times. The image data is introduced into an image analyzing software (Image-Pro PLUS) manufactured by Media Cybernetics Inc., through an interface, and the length of plate-shaped particles in the major axis direction and in the minor axis direction is examined for each particle. The aspect ratio (=length in major direction/length in minor direction) is then calculated and the average value of 100 particles are determined to be the length of particles in the minor axis direction and the aspect ratio.

The volume average particle diameter of the hexagonal plate shaped ferrite powder used in the present invention is preferable to be 3 to 20 µm, more preferable to be 3 to 12 µm. If the volume average particle diameter is less than 3 µm, viscosity of the resin composition to which ferrite powders are added as filler tends to be high and it makes molding difficult. In other words, if the viscosity should be at a certain level, using of the filler smaller than 3 µm only makes content of the filler less and a high filler content is hardly secured. If the volume average particle diameter exceeds 20 µm, viscosity of the resin composition to which ferrite powders are added as filler tends to be low to make molding difficult.

### (Determination of the volume average particle diameter (Micro Track Method) : D₅₀)

The volume average particle diameter is determined as follows. In other words, the volume average particle diameter is determined with a micro track particle size analyzer (Model 9320-X100) manufactured by Nikkiso Co., Ltd. Water is used as a dispersion medium. In a 100-ml beaker, 10 g of the sample powder and 80 ml of water are placed, and 2 to 3 drops of a dispersant (sodium hexametaphosphate) are added therein. Then, dispersion is carried out for 20 seconds using an ultrasonic homogenizer (UH-150 manufactured by SMT Co., Ltd.) set at an output level of 4. Bubbles generated on the surface of the beaker are then removed and the sample suspension is charged into the apparatus.

The hexagonal plate shaped ferrite powder used in the present invention is preferable to be that the amount of Cl eluted is 1 to 100 ppm, more preferably 1 to 50 ppm. If the amount of Cl eluted of the hexagonal plate shaped ferrite powder is in the rage, even the metal powder is contained in a resin molded product in addition to the ferrite powder, the molded product can be used in a stable state for a long time. Although the Cl amount eluted of less than 1 ppm is preferable, Cl derived from impurities contained in raw materials cannot be completely removed. If the amount of Cl eluted exceeds 100 ppm, chlorine contained in the hexagonal plate shaped ferrite powder in a resin molded product may corrodes metal portions such as metal filler contained in the resin molded product and a copper wiring pattern around the resin molded product when the ferrite powder is used as a filler.

Although the detail is not obvious, chlorine influences on the specific crystal plane of the ferrite crystal structure in firing and the growth of crystal planes not influenced by chlorine is accelerated. As a result, the ferrite powder having a high aspect ratio can be manufactured in the ferrite powder containing a certain amount of chlorine that is different from the ferrite powder without chlorine.

### (Determination of the amount of Cl eluted)

### <Cl concentration: method of eluting >

(1) The sample powder accurately weighed in the range of 50.000 g + 0.0002 g is placed in a 150-ml glass bottle.
(2) The phthalate (pH: 4.01) in amount of 50 ml is added into the glass bottle.
(3) The ionic strength adjuster in an amount of 1 ml is further added into the glass bottle, and a lid is put on the glass bottle.
(4) Stirring is carried out for 10 minutes with a paint shaker.
(5) The magnet is pressed on the bottom of the 150-ml glass bottle to prevent the carrier from falling, and the content is filtrated through the paper filter No.5B into a PP container (50 ml).
(6) The voltage of the supernatant liquid is examined with a pH meter.
(7) Solutions having individual Cl concentrations prepared for a calibration curve (pure water, 1 ppm, 10 ppm, 100 ppm and 1000 ppm) are examined in the same manner, and the amount of Cl eluted from the sample powder is calculated from the values.

The hexagonal plate shaped ferrite powder used in the present invention contains 7.8 to 9 wt% of Sr, 61 to 65 wt% of Fe, and 0.1 to 0.65 wt% of Mg. The composition makes the hexagonal plate shaped ferrite powder have a residual magnetization and a coercive force larger than those of spherical hard ferrite particles, and makes magnetic permeability µ" in the specific frequency range. In particular, as containing of Mg in the range makes the peak position of the complex magnetic permeability µ" shift to the vicinity of 800 MHz, the hexagonal plate shaped ferrite powder is preferable to be used as filler in an electromagnetic wave absorber used in a cellular phone.

If the Sr content is less than 7.8 wt%, the Fe content relatively increases and the residual magnetization and the coercive force may be reduced. If the Sr content exceeds 9 wt%, the Fe content relatively decreases and the coercive force may not be sufficiently recovered by the heat treatment after firing. If the Fe content is less than 61 wt%, the coercive force may not be sufficiently recovered by the heat treatment after firing. If the Fe content exceeds 65 wt%, the residual magnetization and the coercive force may decrease. If the Mg content is less than 0.1 wt%, no effect of the addition is expected and desired frequency properties cannot be achieved. If the Mg content exceeds 0.65 wt%, the residual magnetization and the coercive force may decrease.

### (Determination of the content of Fe, Mg and Sr)

The content of Fe, Mg and Sr is determined as follows.

A sample (ferrite powder) in an amount of 0.2 g is weighed and completely dissolved in 60 ml of pure water added 20 ml of 1 N hydrochloric acid and 20 ml of 1 N nitric acid with heating. The content of Fe, Mg and Sr in the aqueous solution thus prepared is determined with ICP analyzer (ICPS-1000IV manufactured by Shimadzu Corporation).

The hexagonal plate shaped ferrite powder used in the present invention is preferable to have the residual magnetization of 27 to 37 Am²/kg and the coercive force of 3000 to 4000 A/m at 10K·1000/4π·A/m. Such magnetic properties make the resin molded added the hexagonal plate shaped ferrite powder as a filler high in magnetic properties.

If the residual magnetization is less than 27 Am²/kg, the resin molded product added the hexagonal plate shaped ferrite powder as a filler cannot achieve the sufficient energy product. The residual magnetization exceeding 37 Am²/kg is not the composition of the present invention. If the coercive force is less than 3000 A/m, the resin molded product added the hexagonal plate shaped ferrite powder as filler cannot achieve the sufficient energy product. The coercive force exceeding 4000 A/m is not the composition of the present invention.

### (Determination of the magnetic properties)

A vibrating sample magnetometer (model: VSM-C7-10A (manufactured by Toei Industry Co., Ltd.)) is used. Examination sample powder filled in the cell with an inner diameter of 5 mm and a height of 2 mm is set in the apparatus. In the examination, sweeping is carried out until 10K·1000/4π·A/m under the magnetic field. Then the magnetic field is reduced to draw a hysteresis curve. Based on the curve data, saturation magnetization, residual magnetization and coercive force are determined.

The BET specific surface area of the hexagonal plate shaped ferrite powder used in the present invention is preferable to be 0.3 to 0.85 m²/g, more preferably 0.4 to 0.8 m²/g. If the BET specific surface area is in the range, a high filling rate is achieved if used as a filler in a resin molded product because the hexagonal plate shaped ferrite powder has a high bulk density even with the hexagonal plate shape.

The BET specific surface area of less than 0.3 m²/g is not preferable because the particle diameter is large and the particle shape may be irregular instead of a hexagonal plate shape. The BET specific surface area of more than 0.85 m²/g is not preferable because the ferrite particles are too small and filling ratio may be reduced when used as filler in a resin molded product.

### (Determination of BET specific surface area)

The BET specific surface area is examined by the BET specific surface area analyzer (Macsorb HM model 1210) manufactured by Mountech Co. The sample powder to be examined is placed in a vacuum dryer and treated at normal temperature for 2 hours. The cell is densely filled with the sample powder and set in the apparatus. The sample powder is subjected to a pretreatment at a deaeration temperature of 40°C for 60 minutes and then examined.

### < Resin composition according to the present invention>

The resin composition according to the present invention includes 50 to 99.5 wt% of the hexagonal plate shaped ferrite powder. If the content of the hexagonal plate shaped ferrite powder is less than 50 wt%, the performance of ferrite cannot be sufficiently shown even though the hexagonal plate shaped ferrite powder is contained. If the content of the hexagonal plate shaped ferrite powder exceeds 99.5 wt%, a few resin is contained and molding may be impossible.

The resin used in the resin composition is selected from an epoxy resin, a phenol resin, a melamine resin, a urea resin, and a fluorine resin. The resin composition may contain a curing agent, a curing accelerator, and various additives such as silica particles according to needs.

### <Molded product according to the present invention>

The molded product according to the present invention is manufactured by molding and heat-curing the resin composition. The molded product is used in applications such as a general-purpose bonded magnet and an LSI encapsulant for absorbing electromagnetic waves.

### <Method of manufacturing the hexagonal plate shaped ferrite powder used in the present invention>

The method of manufacturing the hexagonal plate shaped ferrite powder used in the present invention will be described.

The method of manufacturing the hexagonal plate shaped ferrite powder used in the present invention comprises dry mixing Fe₂O₃, SrCO₃ and MgCl₂ as raw materials. The dry mixing uses a Henschel mixer or the like and granulating in mixing for 1 minute or more, preferably 3 to 60 minutes.

The granulated product is subjected to firing without calcination. The hexagonal plate shaped ferrite powder is manufactured by carrying out firing in the air at 1150 to 1250°C for 2 to 8 hours (peak) in a fixed electric furnace.

Alternatively, the heat-treated hexagonal plate shaped ferrite powder may be manufactured through wet pulverizing the fired product with a bead mill or the like, and heat-treating at 750 to 1050°C for 0.1 to 2 hours after rinsing, dehydrating, and drying.

### <Method of manufacturing the resin composition according to the present invention>

The resin composition according to the present invention is manufactured by mixing the hexagonal plate shaped ferrite powder, the resin, the curing agent, the curing accelerator, and various additives such as silica particles according to needs using a mixer including a roll mill and a kneader.

### <Method of manufacturing the molded product according to the present invention>

The molded product according to the present invention is manufactured by molding and heat curing the resin composition. Examples of the molding method include a doctor-blade method, an extrusion method, a press method, and a calender roll method. The heat curing may be carried out by any one of an external heating method and an internal heating method. For example, baking with a fixed or fluid-bed furnace or a micro-wave, and UV resin curing may be employed. Alternatively, a metal mold or the like may be used in pressure molding with heating.

The present invention will be described more specifically with reference to Examples.

### [Examples]

### <Example 1> (Synthesis)

5.75 mol of Fe₂O₃, 1 mol of SrCO₃, and 0.1 mol of MgCl₂·6H₂O as raw materials of ferrite were mixed in a Henschel mixer for 10 minutes and granulated.

The granulated product was subjected to firing in the air at 1200°C for 4 hours (peak) with a fixed electric furnace to prepare the hexagonal plate shaped ferrite powder.

The heat-treated hexagonal plate shaped ferrite powder was prepared by wet pulverizing with the bead mill with a solid content of 60 wt% for 30 minutes, rinsing, dehydrating, drying, and heat-treating the fired product prepared in the firing in the air at 950°C for 1 hour (peak).

### <Example 2> (Synthesis)

The hexagonal plate shaped ferrite powder and the heat-treated hexagonal plate shaped ferrite powder were prepared in the same manner as in Example 1, except that the firing temperature was set at 1150°C.

### <Example 3> (Synthesis)

The hexagonal plate shaped ferrite powder and the heat-treated hexagonal plate shaped ferrite powder were prepared in the same manner as in Example 1, except that the firing temperature was set at 1220°C.

### <Example 4> (Synthesis)

The hexagonal plate shaped ferrite powder and the heat-treated hexagonal plate shaped ferrite powder were prepared in the same manner as in Example 1, except that 6 mol of Fe₂O₃, 1 mol of SrCO₃, and 0.1 mol of MgCl₂·6H₂O were used as raw materials of ferrite.

### <Example 5> (Synthesis)

The hexagonal plate shaped ferrite powder and the heat-treated hexagonal plate shaped ferrite powder were prepared in the same manner as in Example 1, except that 5.65 mol of Fe₂O₃, 1 mol of SrCO₃, and 0.1 mol of MgCl₂·6H₂O were used as raw materials of ferrite.

### <Example 6> (Synthesis)

The hexagonal plate shaped ferrite powder and the heat-treated hexagonal plate shaped ferrite powder were prepared in the same manner as in Example 1, except that 5.75 mol of Fe₂O₃, 1 mol of SrCO₃, and 0.2 mol of MgCl₂·6H₂O were used as raw materials of ferrite.

### <Example 7> (Synthesis)

The hexagonal plate shaped ferrite powder and the heat-treated hexagonal plate shaped ferrite powder were prepared in the same manner as in Example 1, except that 5.75 mol of Fe₂O₃, 1 mol of SrCO₃, and 0.05 mol of MgCl₂·6H₂O were used as raw materials of ferrite,

### <Example 8> (Synthesis)

The hexagonal plate shaped ferrite powder and the heat-treated hexagonal plate shaped ferrite powder were prepared in the same manner as in Example 1, except that the heat treatment temperature was set at 900°C.

### <Example 9> (Synthesis)

The hexagonal plate shaped ferrite powder and the heat-treated hexagonal plate shaped ferrite powder were prepared in the same manner as in Example 1, except that the heat treatment temperature was set at 1020°C.

### <Comparative Example 1>

The hexagonal plate shaped ferrite powder and the heat-treated hexagonal plate shaped ferrite powder were prepared in the same manner as in Example 1, except that 5.75 mol of Fe₂O₃, 1 mol of SrCO₃, and 0 mol of MgCl₂·6H₂O were used as raw materials of ferrite.

### <Comparative Example 2>

The hexagonal plate shaped ferrite powder and the heat-treated hexagonal plate shaped ferrite powder were prepared in the same manner as in Example 1, except that 5.75 mol of Fe₂O₃, 1 mol of SrCO₃, and 0.3 mol of MgCl₂·6H₂O were used as raw materials of ferrite.

### <Comparative Example 3>

The hexagonal plate shaped ferrite powder and the heat-treated hexagonal plate shaped ferrite powder were prepared in the same manner as in Example 1, except that the firing temperature was set at 1300°C.

### <Comparative Example 4>

The hexagonal plate shaped ferrite powder and the heat-treated hexagonal plate shaped ferrite powder were prepared in the same manner as in Example 1, except that the firing temperature was set at 1050°C.

### <Comparative Example 5>

The hexagonal plate shaped ferrite powder and the heat-treated hexagonal plate shaped ferrite powder were prepared in the same manner as in Example 1, except that an attritor and a spray dryer were used as a raw material mixing system.

Table 1 shows the number of moles of raw materials charged, the conditions for mixing raw materials (mixing machine and mixing time), the conditions of firing (firing atmosphere, firing temperature, and firing time) and magnetic properties at 10K·1000/4π·A/m (saturation magnetization, residual magnetization and coercive force) in Examples 1 to 9 and Comparative Examples 1 to 5.

Table 2 shows the pulverization conditions (apparatus, pulverization time, and solid content), the heat treatment conditions (heat treatment atmosphere, heat treatment temperature, and heat treatment time), the chemical analysis and the magnetic properties (saturation magnetization, residual magnetization, and coercive force) in Examples 1 to 9 and Comparative Examples 1 to 5.

Table 3 shows the average particle diameter (D₁₀, D₅₀ and D₉₀), the BET specific surface area, the particle shape (length in minor axis direction, length in major axis direction, and aspect ratio), the evaluation result on the ferrite particles prepared (frequency properties, amount of chlorine eluted at pH 4 before and after heat treatment, corrosion state of copper) in Examples 1 to 9 and Comparative Examples 1 to 5. Furthermore, Figure 1 shows the frequency dependency of the magnetic permeability µ" in Examples 1 and 6 and Comparative Example 1.

In Tables 1 to 3, the volume average particle diameters D₁₀ and D₉₀ were examined in the same manner as in the examination of D₅₀. The frequency properties (peak position of µ" (MHz)) and the corrosion state of copper were determined as follows. The other examination methods were as described above.

### (Examination of frequency properties of the complex magnetic permeability)

The frequency properties of the complex magnetic permeability were examined as follows.

The examination was carried out using an RF impedance/material analyzer E4991A manufactured by Agilent Technologies Inc., with an electrode for examining magnetic material 16454A.

The sample powders for examining the frequency properties of complex magnetic permeability (hereinafter simply referred to as "sample powder for examining complex magnetic permeability") were prepared as follows. Specifically, 9 g of composite magnetic powder for suppressing noise and 1 g of the binder resin (KYNAR 301F: polyvinylidene fluoride) were weighed and placed in a 50-cc glass bottle for stirring and mixing for 30 minutes with a ball mill with rotation of 100 rpm.

After finishing stirring, about 0.6 g of the mixture was weighed and put into a dice with an inner diameter of 4.5 mm and an outer diameter of 13 mm for pressing under a pressure of 40 MPa for 1 minute with a press machine. A molded product was left standing at 140°C for 2 hours in a hot air dryer to prepare the molded specimen for examining the complex magnetic permeability. Prior to the examination, measured outer diameter, the length in the minor axis direction, and the inner diameter of the molded specimens for examination were inputted into the examination apparatus. The complex magnetic permeability (real part magnetic permeability: µ' and imaginary part magnetic permeability: µ") were examined at an amplitude of 100 mV with a logarithmic sweep in the range of 1 MHz to 1 GHz. On this occasion, 201 points were examined, and the frequency when the magnetic permeability µ" reached a peak value were determined to be the peak frequency of µ". If a plurality of peak values are detected, the average of the frequencies when the magnetic permeability µ" reached peak values were determined to be the peak frequency of µ".

### (Corrosion state of copper)

On the central part of copper plates with a diameter of 4 cm, 1 g of ferrite powders were placed and flattened with 1 Kg of a weight placed thereon. The ferrite powders were then left standing under H/H environment for 2 weeks. After removing the ferrite powders, the corrosion states of copper plates were inspected by the naked eye.

**[Table 1]**

| | Moles of raw material charged | | | Conditions for mixing raw materials | | Firing conditions | | | Magnetic properties (VSM) at 10K·1000/4π·A/m | | |
|---|---|---|---|---|---|---|---|---|---|---|---|
| | Fe₂O₃ | SrCO₃ | MgCl₂·6H₂O | Mixing apparatus | Mixing time (min) | Firing atmosphere | Firing temperature (°C) | Firing time (peak) (hr) | Saturation magnetization (Am²/kg) | Residual magnetization (Am²/kg) | Coercive force (A/m) |
| Example 1 | 5.75 | 1 | 0.1 | Henschel mixer | 10 | Air | 1200 | 4 | 57.13 | 32.99 | 3210 |
| Example 2 | 5.75 | 1 | 0.1 | Henschel mixer | 10 | Air | 1150 | 4 | 58.24 | 32.75 | 3010 |
| Example 3 | 5.75 | 1 | 0.1 | Henschel mixer | 10 | Air | 1220 | 4 | 55.67 | 29.89 | 3560 |
| Example 4 | 6 | 1 | 0.1 | Henschel mixer | 10 | Air | 1200 | 4 | 56.54 | 32.65 | 3090 |
| Example 5 | 5.65 | 1 | 0.1 | Henschel mixer | 10 | Air | 1200 | 4 | 58.29 | 33.48 | 3180 |
| Example 6 | 5.75 | 1 | 0.2 | Henschel mixer | 10 | Air | 1200 | 4 | 57.67 | 34.62 | 3420 |
| Example 7 | 5.75 | 1 | 0.05 | Henschel mixer | 10 | Air | 1200 | 4 | 56.78 | 27.82 | 3510 |
| Example 8 | 5.75 | 1 | 0.1 | Henschel mixer | 10 | Air | 1200 | 4 | 57.13 | 32.99 | 3210 |
| Example 9 | 5.75 | 1 | 0.1 | Henschel mixer | 10 | Air | 1200 | 4 | 57.13 | 32.99 | 3210 |
| Comparative Example 1 | 5.75 | 1 | 0 | Henschel mixer | 10 | Air | 1200 | 4 | 54.89 | 24.93 | 2410 |
| Comparative Example 2 | 5.75 | 1 | 0.3 | Henschel mixer | 10 | Air | 1200 | 4 | 57.98 | 33.01 | 2650 |
| Comparative Example 3 | 5.75 | 1 | 0.1 | Henschel mixer | 10 | Air | 1300 | 4 | 57.61 | 33.06 | 2780 |
| Comparative Example 4 | 5.75 | 1 | 0.1 | Henschel mixer | 10 | Air | 1050 | 4 | 49.41 | 28.07 | 2670 |
| Comparative Example 5 | 5.75 | 1 | 0.1 | Attritor + spray dryer | 10 | Air | 1200 | 4 | 55.71 | 25.34 | 2450 |

**[Table 2]**

| | Pulverization conditions (wet process) | | | Heat treatment conditions | | | Chemical analysis (ICP) (wt%) | | | Magnetic properties (VSM) at 10K·1000/4π·A/m | | |
|---|---|---|---|---|---|---|---|---|---|---|---|---|
| | Apparatus | Pulverization time (min) | Solid content (wt%) | Heat treatment atmosphere | Heat treatment temperature (°C) | Treatment time (peak) (hr) | Fe | Sr | Mg | Saturation magnetization (Am²/kg) | Residual magnetization (Am²/kg) | Coercive force (A/m) |
| Example 1 | Bead mill | 30 | 60 | Air | 950 | 1 | 62.69 | 8.44 | 0.23 | 55.01 | 33.21 | 3227 |
| Example 2 | Bead mill | 30 | 60 | Air | 950 | 1 | 62.64 | 8.50 | 0.23 | 58.06 | 33.31 | 3225 |
| Example 3 | Bead mill | 30 | 60 | Air | 950 | 1 | 62.85 | 8.27 | 0.22 | 53.07 | 30.44 | 3820 |
| Example 4 | Bead mill | 30 | 60 | Air | 950 | 1 | 63.12 | 7.94 | 0.22 | 55.92 | 32.92 | 3280 |
| Example 5 | Bead mill | 30 | 60 | Air | 950 | 1 | 62.71 | 8.43 | 0.23 | 58.03 | 33.79 | 3211 |
| Example 6 | Bead mill | 30 | 60 | Air | 950 | 1 | 62.49 | 8.37 | 0.46 | 55.57 | 34.97 | 3648 |
| Example 7 | Bead mill | 30 | 60 | Air | 950 | 1 | 62.82 | 8.45 | 0.12 | 54.2 | 28.1 | 3609 |
| Example 8 | Bead mill | 30 | 60 | Air | 900 | 1 | 62.55 | 8.61 | 0.24 | 56.4 | 33.32 | 3419 |
| Example 9 | Bead mill | 30 | 60 | Air | 1020 | 1 | 62.73 | 8.39 | 0.23 | 56 | 33.51 | 3386 |
| Comparative Example 1 | Bead mill | 30 | 60 | Air | 950 | 1 | 62.90 | 8.52 | 0.00 | 54.19 | 25.36 | 2519 |
| Comparative Example 2 | Bead mill | 30 | 60 | Air | 950 | 1 | 62.09 | 8.51 | 0.71 | 57.75 | 33.12 | 2718 |
| Comparative Example 3 | Bead mill | 30 | 60 | Air | 950 | 1 | 62.74 | 8.39 | 0.23 | 55.7 | 33.32 | 2395 |
| Comparative Example 4 | Bead mill | 30 | 60 | Air | 950 | 1 | 62.60 | 8.55 | 0.24 | 48.37 | 28.45 | 2106 |
| Comparative Example 5 | Bead mill | 30 | 60 | Air | 950 | 1 | 62.58 | 8.57 | 0.23 | 53.99 | 25.65 | 2340 |

**[Table 3]**

| | Powder properties | | | | | | | Evaluation results on ferrite powder prepared | | | |
|---|---|---|---|---|---|---|---|---|---|---|---|
| | Average particle diameter (micro track method) (µm) | | | BET specific surface area (m²/kg) | Particle shape | | | Frequency properties | Amount of Cl eluted at pH 4 before heat treatment (ppm) | Amount of Cl eluted at pH 4 after heat treatment (ppm) | Corrosion state of copper |
| | D₁₀ | D₅₀ | D₉₀ | | Length in minor axis direction (µm) | Length in major axis direction (µm) | Aspect ratio | Peak position of µ" (MHz) | | | |
| Example 1 | 21.12 | 9.05 | 3.64 | 0.6177 | 1.5 | 8.5 | 5.67 | 867 | 1230 | 15 | Good |
| Example 2 | 21.27 | 9.19 | 3.29 | 0.7891 | 2.5 | 12.3 | 4.92 | 817 | 980 | 17 | Good |
| Example 3 | 20.46 | 9.28 | 3.18 | 0.5312 | 1.2 | 7.1 | 5.92 | 903 | 1540 | 19 | Good |
| Example 4 | 20.67 | 9.22 | 3.30 | 0.5567 | 1.3 | 9.1 | 7 | 817 | 1320 | 21 | Good |
| Example 5 | 20.35 | 8.79 | 3.28 | 0.6541 | 2.3 | 9.2 | 4 | 801 | 1160 | 12 | Good |
| Example 6 | 21.21 | 9.07 | 3.61 | 0.7720 | 1.4 | 10.4 | 7.43 | 833 | 1890 | 34 | Good |
| Example 7 | 20.34 | 9.33 | 3.33 | 0.4876 | 1.1 | 8.9 | 8.09 | 885 | 780 | 9 | Good |
| Example 8 | 20.38 | 9.47 | 3.68 | 0.6609 | 1.6 | 8.2 | 5.13 | 922 | 1230 | 25 | Good |
| Example 9 | 21.27 | 8.87 | 3.29 | 0.5980 | 1.4 | 8.6 | 6.14 | 850 | 1230 | 13 | Good |
| Comparative Example 1 | 20.54 | 9.13 | 3.38 | 0.3805 | 1.4 | 4.9 | 3.5 | 710 | 650 | 26 | Good |
| Comparative Example 2 | 20.93 | 9.24 | 3.29 | 0.9805 | 1.3 | 10.2 | 7.85 | 769 | 3450 | 545 | Not Good |
| Comparative Example 3 | 76.34 | 31.88 | 15.42 | 0.2890 | Irregular | Irregular | - | 785 | 870 | 10 | Good |
| Comparative Example 4 | 20.93 | 9.09 | 3.66 | 0.8910 | 1 | 4.1 | 4.1 | 867 | 2230 | 45 | Good |
| Comparative Example 5 | 76.34 | 31.88 | 15.42 | 0.2541 | Irregular | Irregular | - | 682 | 690 | 21 | Good |

| | | | | | | | | | | | |
|---|---|---|---|---|---|---|---|---|---|---|---|
| Corrosion state of copper: Good: No corrosion is observed. Not Good: Corrosion with deposition of patina is observed. | | | | | | | | | | | |

As is evident in Tables 2 and 3, the ferrite powders prepared in Examples 1 to 9 have the hexagonal plate shape, achieve desired high values in the residual magnetization and coercive force, and cause no copper corrosion due to chlorine eluted in a satisfactory range.

In contrast, the residual magnetization and coercive force in Comparative Example 1 are low. The coercive force is also low and mild corrosion in copper is observed in Comparative 2 due to a large amount of chlorine eluted.

Comparative Example 3 is not only low in the coercive force but also the shape is irregular. Comparative Example 4 is low in any of magnetic properties (saturation magnetization, residual magnetization and coercive force).

Comparative Example 5 is low in the residual magnetization and coercive force and the shape is irregular.

### <Example 10>

A cylindrical specimen with a diameter of 5 mm and a height of 3 mm for examining the magnetic properties was molded from the ferrite powder prepared in Example 1 in the same manner for examining the magnetic permeability, and the magnetic properties (saturation magnetization, residual magnetization and coercive force) were examined.

The sufficient magnetic force for the close contact with a magnetic metal was confirmed, i.e. a saturation magnetization of 51.21 (Am²/kg), a residual magnetization of 27.08 (Am²/kg), and a coercive force of 2261 (A/m).

### [Industrial Applicability]

As the hexagonal plate shaped ferrite powder used in the present invention has a hexagonal plate shape and a specific composition, the residual magnetization and the coercive force thereof are larger than those of spherical hard ferrite powder, and the magnetic permeability µ" in each frequency band has a specific value. A resin molded product having specific frequency properties is manufactured by manufacturing the resin composition containing the hexagonal plate shaped ferrite powder as a filler and molding the resin composition. If the hexagonal plate shaped ferrite powder is used as a filler, a resin molded product having a larger energy product than that of a spherical ferrite powder can be manufactured.

As a result, the resin molded product can be suitably used as a radio wave absorber in frequency bands.

## Claims

1. A resin composition containing a resin and 50 to 99.5 wt% of a hexagonal plate shaped ferrite powder, wherein the hexagonal plate shaped ferrite powder contains 7.8 to 9 wt% of Sr, 61 to 65 wt% of Fe, and 0.1 to 0.65 wt% of Mg,
the hexagonal plate shaped ferrite powder has a length in the minor axis direction of 0.5 to 3 µm and an aspect ratio of 3.5 to 9, and
wherein the resin is selected from an epoxy resin, a phenol resin, a melamine resin, a urea resin, and a fluorine resin.

2. The resin composition according to claim 1, wherein the hexagonal plate shaped ferrite powder includes an aggregate of the hexagonal plate shaped ferrite powder.

3. The resin composition according to claim 1 or 2, wherein the hexagonal plate shaped ferrite powder has a volume average particle diameter of 3 to 20 µm.

4. The resin composition according to any one of claims 1 to 3, wherein the hexagonal plate shaped ferrite powder has an amount of Cl eluted of 1 to 100 ppm.

5. A molded product formed from the resin composition according to any one of claims 1 to 4.

6. A radio wave absorber comprising the resin molded product according to claim 5.

7. A method of manufacturing a resin composition according to any one of claims 1 to 4, wherein the method comprises the steps of:
dry mixing Fe₂O₃, SrCO₃ and MgCl₂ as raw materials, and firing the mixture as it is to provide a hexagonal plate shaped ferrite powder containing 7.8 to 9 wt% of Sr, 61 to 65 wt% of Fe, and 0.1 to 0.65 wt% of Mg; and
combining the hexagonal plate shaped ferrite powder with a resin selected from an epoxy resin, a phenol resin, a melamine resin, a urea resin, and a fluorine resin.

8. The method of manufacturing a resin composition according to claim 7, wherein the method further comprises wet pulverizing the fired product manufactured by the firing, and heat treating the pulverized product at 750 to 1050°C after rinsing, dehydrating, and drying.

## Patentansprüche

1. Eine Harzzusammensetzung, enthaltend ein Harz und 50 bis 99,5 Gew.-% eines Ferritpulvers in Form hexagonaler Plättchen, wobei das Ferritpulver in Form hexagonaler Plättchen 7,8 bis 9 Gew.-% Sr, 61 bis 65 Gew.-% Fe und 0,1 bis 0,65 Gew.-% Mg enthält,
das Ferritpulver in Form hexagonaler Plättchen eine Länge in Richtung der Nebenachse von 0,5 bis 3 µm und ein Seitenverhältnis von 3,5 bis 9 aufweist, und
wobei das Harz aus einem Epoxidharz, einem Phenolharz, einem Melaminharz, einem Harnstoffharz und einem Fluorharz ausgewählt ist.

2. Die Harzzusammensetzung nach Anspruch 1, wobei das Ferritpulver in Form hexagonaler Plättchen ein Aggregat des Ferritpulvers in Form hexagonaler Plättchen beinhaltet.

3. Die Harzzusammensetzung nach Anspruch 1 oder 2, wobei das Ferritpulver in Form hexagonaler Plättchen einen volumengemittelten Teilchendurchmesser von 3 bis 20 µm aufweist.

4. Die Harzzusammensetzung nach einem der Ansprüche 1 bis 3, wobei das Ferritpulver in Form hexagonaler Plättchen eine Menge an eluiertem Cl von 1 bis 100 ppm aufweist.

5. Ein Formgegenstand, der aus einer Harzzusammensetzung nach einem der Ansprüche 1 bis 4 gebildet ist.

6. Ein Radiowellenabsorber, umfassend den Harzformgegenstand nach Anspruch 5.

7. Ein Verfahren zur Herstellung einer Harzzusammensetzung nach einem der Ansprüche 1 bis 4, wobei das Verfahren die Schritte umfasst:
Trockenmischen von Fe₂O₃, SrCO₃ und MgCl₂ als Ausgangsmaterialien und Brennen des Gemischs so wie es ist, um ein Ferritpulver in Form hexagonaler Plättchen bereitzustellen, das 7,8 bis 9 Gew.-% Sr, 61 bis 65 Gew.-% Fe und 0,1 bis 0,65 Gew.-% Mg enthält; und
Kombinieren des Ferritpulvers in Form hexagonaler Plättchen mit einem Harz, ausgewählt aus einem Epoxidharz, einem Phenolharz, einem Melaminharz, einem Harnstoffharz und einem Fluorharz.

8. Das Verfahren zur Herstellung einer Harzzusammensetzung nach Anspruch 7, wobei das Verfahren ferner Nasspulverisieren des durch Brennen hergestellten gebrannten Produkts und Wärmebehandeln des pulverisierten Produkts bei 750 bis 1050°C nach Spülen, Entwässern und Trocknen umfasst.

## Revendications

1. Composition de résine contenant une résine et 50 à 99,5 % en poids d'une poudre de ferrite en forme de plaque hexagonale, dans laquelle la poudre de ferrite en forme de plaque hexagonale contient 7,8 à 9 % en poids de Sr, 61 à 65 % en poids de Fe, et 0,1 à 0,65 % en poids de Mg,
la poudre de ferrite en forme de plaque hexagonale a une longueur dans la direction de l'axe mineur de 0,5 à 3 µm et un rapport d'aspect de 3,5 à 9, et
dans laquelle la résine est choisie parmi une résine époxy, une résine phénolique, une résine de mélamine, une résine d'urée, et une résine fluorée.

2. Composition de résine selon la revendication 1, dans laquelle la poudre de ferrite en forme de plaque hexagonale comprend un agrégat de la poudre de ferrite en forme de plaque hexagonale.

3. Composition de résine selon la revendication 1 ou 2, dans laquelle la poudre de ferrite en forme de plaque hexagonale a une granulométrie moyenne en volume de 3 à 20 µm.

4. Composition de résine selon l'une quelconque des revendications 1 à 3, dans laquelle la poudre de ferrite en forme de plaque hexagonale a une quantité de Cl élué de 1 à 100 ppm.

5. Produit moulé formé à partir de la composition de résine de l'une quelconque des revendications 1 à 4.

6. Absorbeur d'ondes radio comprenant le produit moulé en résine de la revendication 5.

7. Méthode de fabrication d'une composition de résine de l'une quelconque des revendications 1 à 4, dans laquelle la méthode comprend les étapes de :
mélange à sec de Fe₂O₃, SrCO₃ et MgCl₂ en tant que matières premières, et cuisson du mélange tel quel pour former une poudre de ferrite en forme de plaque hexagonale contenant 7,8 à 9 % en poids de Sr, 61 à 65 % en poids de Fe, et 0,1 à 0,65 % en poids de Mg ; et
combinaison de la poudre de ferrite en forme de plaque hexagonale avec une résine choisie parmi une résine époxy, une résine phénolique, une résine de mélamine, une résine d'urée, et une résine fluorée.

8. Méthode de fabrication d'une composition de résine selon la revendication 7, laquelle méthode comprend en outre la pulvérisation à l'état humide du produit cuit fabriqué par la cuisson, et le traitement à la chaleur du produit pulvérisé à une température de 750 à 1050 °C après rinçage, déshydratation, et séchage.
